# EUROPÄISCHE PATENTANMELDUNG

(11) **EP 3 389 087 A1**
(43) Veröffentlichungstag der Anmeldung: **17.10.2018**
(21) Anmeldenummer: 17166424.6
(22) Anmeldetag: 13.04.2017
(51) Int. Cl.: H01L 23/427, H01L 23/373

(54) **MODUL MIT EINEM LEISTUNGSHALBLEITER**

(71) Anmelder: Siemens Aktiengesellschaft, 80333 München (DE)
(72) Erfinder: Danov, Vladimir, 91056 Erlangen (DE); Ippisch, Stephan, 91054 Erlangen (DE); Kraus, Ludwig, 94099 Ruhstorf (DE); Müller, Volker, 90408 Nürnberg (DE)

(57) **Zusammenfassung**

Es wird ein Modul (1), umfassend einen Leistungshalbleiter (41) und eine Grundplatte (42) vorgeschlagen, wobei der Leistungshalbleiter (41) zur Kühlung auf der Grundplatte (42) wenigstens teilweise angeordnet ist. Erfindungsgemäß ist die Grundplatte (42) eine Verdampfungskammer (42).

Weiterhin betrifft die Erfindung einen Stromrichter sowie ein Verfahren zur Kühlung eines Leistungshalbleiters (41).

## Beschreibung

Die Erfindung betrifft ein Modul mit einem Leistungshalbleiter gemäß dem Obergriff des Patentanspruches 1, einen Stromrichter gemäß dem Oberbegriff des Patentanspruches 8 sowie ein Verfahren zur Kühlung eines Leistungshalbleiters gemäß dem Oberbegriff des Patentanspruches 9.

Während eines Betriebes von Leistungshalbleitern, insbesondere eines Bipolartransistors mit isolierter Gate-Elektrode (englisch: Insulated Gate Bipolar Transistor, abgekürzt IGBT), wird Wärme erzeugt, die abgeführt werden muss (Abwärme). Insbesondere erfordert eine Erhöhung der Leistungsdichte von Leistungshalbleitern eine entsprechend höher dimensionierte Kühlung.

Typische IGBT sind zur Kühlung auf einer massiven Grundplatte angeordnet, die bezüglich des IGBT eine besonders große Dicke aufweist. Mittels der Grundplatte wird die Abwärme an die Umgebung des IGBT abgegeben. Weiterhin wird die Abwärme über die gegenüber dem IGBT vergrößerte Fläche der Grundplatte verteilt. An der dem IGBT abgewandten Seite der Grundplatte kann ein zusätzlicher Kühlkörper angeordnet sein.

Dadurch wird der gesamte Aufbau des Moduls, umfassend einen IGBT, der auf einer Grundplatte angeordnet ist, vergrößert und weniger kompakt. Weiterhin ist die Leistungsdichte im Wesentlichen durch die mögliche maximale Kühlung des IGBT begrenzt.

Der vorliegenden Erfindung liegt die Aufgabe zugrunde, die Kühlung eines Moduls mit einem Leistungshalbleiter oder eines Stromrichters mit einem solchen Modul zu verbessern.

Die Aufgabe wird durch ein Modul mit den Merkmalen des unabhängigen Patentanspruches 1, durch einen Stromrichter mit den Merkmalen des unabhängigen Patentanspruches 8 sowie durch ein Verfahren mit den Merkmalen des unabhängigen Patentanspruches 9 gelöst. In den abhängigen Patentansprüchen sind vorteilhafte Ausgestaltungen und Weiterbildungen der Erfindung angegeben.

Das erfindungsgemäße Modul umfasst einen Leistungshalbleiter, insbesondere einen IGBT, und eine Grundplatte, wobei der Leistungshalbleiter zur Kühlung an der Grundplatte wenigstens teilweise angeordnet ist. Erfindungsgemäß ist die Grundplatte eine Verdampfungskammer (englisch: Vapor Chamber).

Der Leistungshalbleiter kann als IGBT, als Diode oder als Metall-Oxid-Halbleiter-Feldeffekttransistor (englisch: Metal-Oxide-Semiconductor Field-Effect Transistor; abgekürzt: MOSFET) ausgebildet sein. Weiterhin kann der Leistungshalbleiter die genannten Komponenten einzeln oder in einer Mehrzahl sowie weitere elektronische oder elektrische Komponenten umfassen.

Besonders bevorzugt ist wenigstens eine Seite des Leistungshalbleiters vollständig auf der Grundplatte angeordnet. Es ist nicht erforderlich, dass der Leistungshalbleiter direkt an der Grundplatte angeordnet ist, sodass weitere Elemente oder Schichten zwischen dem Leistungshalbleiter und der Grundplatte vorgesehen sein können. Der Leistungshalbleiter kann jedoch direkt an der Grundplatte angeordnet sein.

Durch die vorliegende Erfindung wird die Kühlung des Moduls beziehungsweise des Leistungshalbleiters, insbesondere des IGBT, gegenüber einer massiv ausgeführten Grundplatte verbessert. Das ist deshalb der Fall, da durch die Verdampfungskammer die Wärmeleitfähigkeit sowie die flächenbezogene Spreizung oder Aufteilung der Abwärme verbessert wird. Die Verdampfungskammer hat daher zwei wesentliche technische Wirkungen. Sie verbessert zum einen den Transport der Wärme (Wärmeleitfähigkeit) und zum anderen wird die transportierte und vom Leistungshalbleiter abgeführte Abwärme über eine größere Fläche verteilt. Die Wärmeleitfähigkeit der Verdampfungskammer kann um einen Faktor 1000 gegenüber Kupfer erhöht sein.

Ein weiterer Vorteil der Verdampfungskammer ist, dass dadurch das Modul deutlich kompakter ausgebildet ist. Das ist deshalb der Fall, da keine ausreichend Dicke Grundplatte erforderlich ist, um den Wärmetransport zu erhöhen. Mit anderen Worten kann aufgrund der guten Wärmeleitfähigkeit der Verdampfungskammer diese vergleichsweise dünn ausgestaltet werden und dennoch ein ausreichender Abtransport der Abwärme sichergestellt werden.

Durch die vorliegende Erfindung kann folglich die Leistungsdichte eines Moduls mit wenigstens einem Leistungshalbleiter, insbesondere wenigstens einem IGBT, erhöht werden.

Bei einer Verdampfungskammer wird die Abwärme verwendet um ein sich innerhalb der Verdampfungskammer vorhandenes Fluid wenigstens teilweise zu verdampfen. Hierbei wird das Fluid an einer ersten Seitenfläche (Verdampfungsseite) der Verdampfungskammer, an welcher der Leistungshalbleiter angeordnet ist, verdampft. An einer zweiten Seitenfläche (Kondensationsseite) kondensiert das verdampfte Fluid wenigstens teilweise und gibt hierbei seine vorher durch seine Verdampfung aufgenommen Wärme (Abwärme des Leistungshalbleiters) an die zweite Seitenfläche ab. Über die zweite Seitenfläche, an der beispielsweise ein Kühlkörper, insbesondere Kühlrippen, angeordnet sind, wird die Wärme an die Umgebung abgegeben. Das kondensierte Fluid wird wieder zurück zur Verdampfungsseite geführt, wodurch ein Kreislauf aus Verdampfung und Kondensation ausgebildet wird.

Der erfindungsgemäße Stromrichter, insbesondere ein Gleichrichter oder ein Umrichter, ist dadurch gekennzeichnet, dass dieser wenigstens ein Modul gemäß der vorliegenden Erfindung oder einer ihrer Ausgestaltungen umfasst.

Es ergeben sich zum erfindungsgemäßen Modul gleichartige und gleichwertige Vorteile des erfindungsgemäßen Stromrichters.

Das erfindungsgemäße Verfahren zur Kühlung eines Leistungshalbleiters, insbesondere eines IGBT, ist dadurch gekennzeichnet, dass der Leistungshalbleiter mittels einer Verdampfungskammer gekühlt wird.

Hierbei ist der Leistungshalbleiter mit der Verdampfungskammer thermisch gekoppelt. Weiterhin ist der Leistungshalbleiter an einer Oberfläche beziehungsweise Seitenfläche der Verdampfungskammer angeordnet. Mit anderen Worten wird die bekannte Grundplatte eines Leistungshalbleiters durch die Verdampfungskammer ausgebildet. Auf eine bekannte massive Grundplatte kann dadurch verzichtet werden.

Es ergeben sich zum erfindungsgemäßen Modul gleichartige und gleichwertige Vorteile des erfindungsgemäßen Verfahrens.

Zur Rückführung eines für die Verdampfungskammer vorgesehenen Fluids kann die Verdampfungskammer bevorzugt eine Struktur zur Bildung von Kapillaren für das Fluid umfasst.

Mit anderen Worten umfasst die Verdampfungskammer eine Kapillarstruktur. Mittels der Kapillarstruktur kann das Fluid vorteilhafterweise ohne einer Verwendung von Pumpen, auch gegen die Schwerkraft, zurück zur Verdampfungsseite geführt werden. Dadurch wird eine Selbstregelung der Verdampfungskammer ermöglicht.

Gemäß einer vorteilhaften Ausgestaltung der Erfindung weist die Verdampfungskammer ein Aspektverhältnis größer als eins auf.

Vorteilhafterweise wird dadurch eine möglichst dünne und planare Verdampfungskammer ausgebildet. Dadurch werden eine verbesserte Verteilung der Abwärme und eine kompaktere Bauweise des Moduls ermöglicht.

In einer vorteilhaften Weiterbildung der Erfindung ist zwischen dem Leistungshalbleiter und der Verdampfungskammer ein Wärmeleitmittel angeordnet.

Dadurch wird vorteilhafterweise die thermische Kopplung zwischen dem Leistungshalbleiter, insbesondere IGBT, und der Verdampfungskammer verbessert, sodass die Abwärme des Leistungshalbleiters, insbesondere des IGBT, verbessert abgeführt wird.

Gemäß einer vorteilhaften Weiterbildung der Erfindung weist die Verdampfungskammer eine Einleitungsöffnung und eine Ausleitungsöffnung für ein Fluid auf.

Hierbei ist die Verdampfungskammer im wesentlich hohl ausgebildet. Zum Abtransport der Abwärme, das heißt zur Kühlung des Leistungshalbleiters, wird das Fluid durch die Einleitungsöffnung in seinem flüssigen Aggregatzustand in die Verdampfungskamer geleitet. In der Verdampfungskammer verdampft das Fluid aufgrund der aufgenommen Abwärme wenigstens teilweise. Anschließend wird der Dampf (verdampftes Fluid) mittels der Ausleitungsöffnung aus der Verdampfungskammer ausgeleitet und kann anschließend extern gekühlt und somit wieder kondensiert werden. Eine Rückführung des wieder kondensierten Fluids zur Einleitungsöffnung ist vorteilhaft.

Bevorzugt weist die Verdampfungskammer ein Dochtmaterial für ein Fluid auf.

Dadurch wird eine besonders vorteilhafte Führung, insbesondere eine Rückführung, des flüssigen Fluids von der Kondensationseite der Verdampfungskammer zur Verdampfungseite der Verdampfungskammer ermöglicht. Das flüssige beziehungsweise kondensierte Fluid wird hierbei mittels des Dochtmaterials wenigstens teilweise geführt.

Besonders bevorzugt ist das Dochtmaterial an den innenliegenden Wänden oder Seiten der Verdampfungskammer angeordnet.

Bevorzugt umfasst die Verdampfungskammer ein Fluid.

Insbesondere sind hierbei, gegebenfalls abhängig von der Temperatur oder Verdampfungstemperatur, Wasser, R134a, R227ea oder Fluide mit Fluorketone von Vorteil, insbesondere das Fluid mit dem Handelsnamen Novec™.

Weitere Vorteile, Merkmale und Einzelheiten der Erfindung ergeben sich aus dem im Folgenden beschriebenen Ausführungsbeispielen sowie anhand der Zeichnungen. Dabei zeigen schematisiert:
- Figur 1: eine erste Schnittdarstellung eines Moduls mit einem Leistungshalbleiter und einer Verdampfungskammer; und
- Figur 2: eine zweite Schnittdarstellung eines Moduls mit einem Leistungshalbleiter und einer weiteren Verdampfungskammer;

Gleichartige, gleichwertige oder gleichwirkende Elemente können in den Figuren mit denselben Bezugszeichen versehen sein.

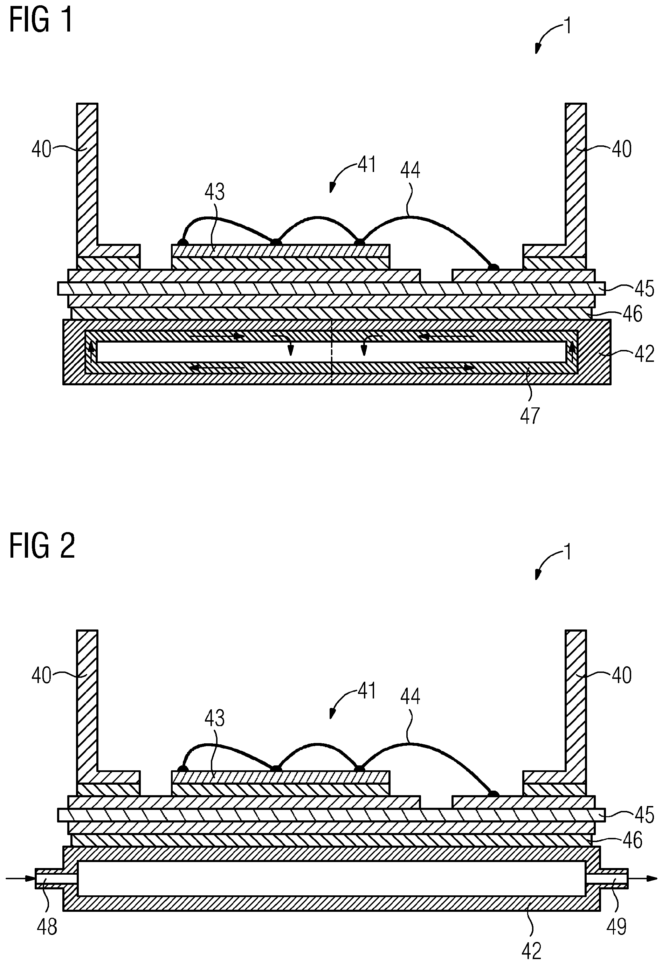

Die Figur 1 zeigt eine schematische Schnittdarstellung eines Moduls 1 mit einem Leistungshalbleiter 41 und einer Grundplatte 42, die als Verdampfungskammer 42 ausgebildet ist. Der Leistungshalbleiter 41 ist an der Verdampfungskammer 42 angeordnet. Hierbei ist zwischen dem Leistungshalbleiter 41 und der Verdampfungskammer 42 ein Wärmeleitmittel 46, insbesondere ein Lot, angebracht. Weitere Elemente oder Schichten zwischen dem Leistungshalbleiter 41 und der Verdampfungskammer 42 können vorgesehen sein.

Die Verdampfungskammer 42 ist im dargestellten Schnitt rechteckförmig ausgebildet. Hierbei ist der Leistungshalbleiter 41 an einer Längsseite der Verdampfungskammer 42 angeordnet. Dadurch wird eine möglichst große Fläche der Verdampfungskammer 42 als auch des Leistungshalbleiters 41 für die thermische Kopplung verwendet.

Die Verdampfungskammer 42 weist weiterhin ein Fluid sowie ein Dochtmaterial 47 zur Rückführung des Fluids von einer Verdampfungsseite der Verdampfungskammer 42 zu einer Kondensationsseite der Verdampfungskammer 42 auf. Die innerhalb des Dochtmaterials 47 dargestellten Pfeile deuten diese Rückführung des Fluids an.

Der Leistungshalbleiter 41 ist an der Verdampfungsseite angeordnet. Die Kondensationsseite kann eine zusätzliche Kühlvorrichtung, insbesondere Kühlrippen, aufweisen. Weiterhin kann die Verdampfungskammer 42 Kapillarstrukturen zur Rückführung des Fluids aufweisen.

Der Leistungshalbleiter 41 weist weiterhin einen Silizium-Chip 43 und/oder einen Silizium-Carbid-Chip (SiC) und/oder weitere Arten eines Chips, Anschlüsse 40 sowie Bonddrähte 44 und/oder eine SIPLIT-Verbindung und/oder SKiN-Verbindung und/oder weitere Verbindungsarten auf. Der Silizium-Chip 43 ist auf einem Kupfer-Substrat (englisch: Direct Copper Bonding; abgekürzt DCB) angeordnet.

In dem in Figur 1 dargestellten Ausführungsbeispiel ist die Verdampfungskammer 42 geschlossen ausgebildet.

Alternativ kann die Verdampfungskammer 42 offen ausgestaltet sein, das heißt eine Einleitungsöffnung und eine Ausleitungsöffnung für das Fluid aufweisen. Ein solches Modul ist in Figur 2 dargestellt.

Die Figur 2 zeigt im Wesentlichen ein gleiches Modul 1 wie bereits Figur 1. Im Unterschied zu Figur 1 weist die Verdampfungskammer 42 eine Einleitungsöffnung 48 und eine Ausleitungsöffnung 49 für das Fluid auf. Hierbei ist die Verdampfungskammer 42 hohl ausgebildet.

Mit anderen Worten umfasst die Verdampfungskammer 42 einen innenliegenden Hohlraum, in welchem das Fluid mittels der Einleitungsöffnung 48 eingeleitet wird. Innerhalb des Hohlraumes verdampft das Fluid wenigstens teilweise und nimmt dadurch die Abwärme des Leistungshalbleiters 41 wenigstens teilweise auf. Mittels der Ausleitungsöffnung 49 wird das verdampfte Fluid aus dem Hohlraum ausgeleitet. Das ausgeleitet verdampfte Fluid kann dann kondensiert und wieder zur Einleitungsöffnung 48 zu einer weiteren Verdampfung rückgeführt werden. Dadurch bildet die Verdampfungskammer 42 einen Verdampfer einer Thermosiphonkühlung aus.

Die weiteren Elemente des in Figur 2 dargestellten Moduls 1 entsprechen den Elementen aus Figur 1.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

## Patentansprüche

1. Modul (1), umfassend einen Leistungshalbleiter (41) und eine Grundplatte (42), wobei der Leistungshalbleiter (41) zur Kühlung an der Grundplatte (42) wenigstens teilweise angeordnet ist, **dadurch gekennzeichnet, dass** die Grundplatte (42) eine Verdampfungskammer (42) ist.

2. Modul (1) gemäß Anspruch 1, **dadurch gekennzeichnet, dass** die Verdampfungskammer (42) eine Struktur zur Bildung von Kapillaren für ein Fluid umfasst.

3. Modul (1) gemäß Anspruch 1 oder 2, **dadurch gekennzeichnet, dass** die Verdampfungskammer (42) ein Aspektverhältnis größer als eins aufweist.

4. Modul (1) gemäß einem der vorhergehenden Ansprüche, **dadurch gekennzeichnet, dass** zwischen dem Leistungshalbleiter (41) und der Verdampfungskammer (42) ein Wärmeleitmittel (46) angeordnet ist.

5. Modul (1) gemäß einem der vorhergehenden Ansprüche, **dadurch gekennzeichnet, dass** die Verdampfungskammer (42) eine Einleitungsöffnung (48) und eine Ausleitungsöffnung (49) für ein Fluid aufweist.

6. Modul (1) gemäß einem der vorhergehenden Ansprüche, **dadurch gekennzeichnet, dass** die Verdampfungskammer (42) ein Dochtmaterial (47) für ein Fluid umfasst.

7. Modul (1) gemäß einem der vorhergehenden Ansprüche, **dadurch gekennzeichnet, dass** die Verdampfungskammer (42) ein Fluid umfasst.

8. Stromrichter, **dadurch gekennzeichnet, dass** dieser wenigstens ein Modul (19) gemäß einem der Ansprüche 1 bis 7 umfasst.

9. Verfahren zur Kühlung eines Leistungshalbleiters (41), **dadurch gekennzeichnet, dass** der Leistungshalbleiter (41) mittels einer Verdampfungskammer (42) gekühlt wird.
